Europäisches Patentamt

European Patent Office

Office européen des brevets

(19)

(11) EP 0 884 840 A2

(12) EUROPEAN PATENT APPLICATION

(43) Date of publication:
16.12.1998 Bulletin 1998/51

(51) Int. Cl.⁶: H03H 9/17

(21) Application number: 98109649.8

(22) Date of filing: 27.05.1998

(84) Designated Contracting States:
AT BE CH CY DE DK ES FI FR GB GR IE IT LI LU MC NL PT SE
Designated Extension States:
AL LT LV MK RO SI

(30) Priority: 12.06.1997 JP 155281/97

(71) Applicant:
MURATA MANUFACTURING CO., LTD.
Nagaokakyo-shi Kyoto-fu (JP)

(72) Inventors:
• Kaida, Hiroaki
  Murata Manufacturing Co., Ltd.
  Nagaokakyo-shi, Kyoto-fu (JP)
• Yamada, Mitsuhiro
  Nagaokakyo-shi, Kyoto-fu (JP)
• Inoue, Jiro
  Nagaokakyo-shi, Kyoto-fu (JP)

(74) Representative:
Laufhütte, Dieter, Dr.-Ing. et al
Lorenz-Seidler-Gossel
Widenmayerstrasse 23
80538 München (DE)

(54) **Thickness extensional vibration mode piezoelectric resonator**

(57) A thickness extensional piezoelectric resonator 1 comprises a rectangular piezoelectric strip 2, first and second excitation electrodes 3, 4 formed on both faces of the piezoelectric strip 2, and an internal electrode 6 disposed inside the piezoelectric strip. The first and second excitation electrodes 3 and 4 are located on opposite sides of the piezoelectric strip 2. The internal electrode 6 is located opposite to the first and second excitation electrodes 3, 4. Assuming that the piezoelectric plate 2 has a width W and a thickness t, the piezoelectric plate is so dimensioned that W/d is less than 6.1 if $d = t/n$.

This thickness extensional piezoelectric resonator can be fabricated in smaller size. The resonator can effectively suppress unwanted spurious vibrations.

EP 0 884 840 A2

Printed by Xerox (UK) Business Services
2.16.6/3.4

## Description

The present invention relates to a piezoelectric resonator used in various resonators, oscillators, and similar devices and, more particularly, to a thickness extensional piezoelectric resonator making use of harmonics of a thickness extensional vibration mode.

Piezoelectric resonators are used in various piezoelectric resonator parts such as piezoelectric oscillators and piezoelectric filters. Known piezoelectric resonators of this kind utilize various piezoelectric vibration modes, depending on the used frequency.

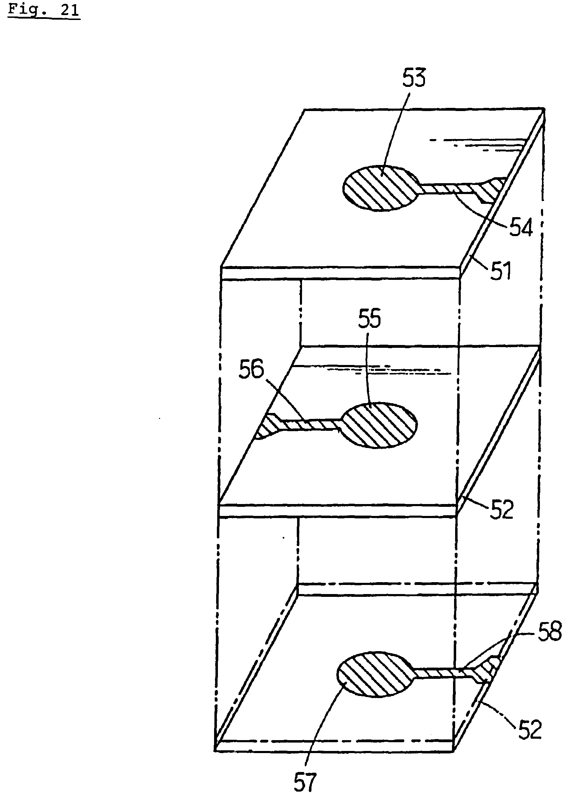

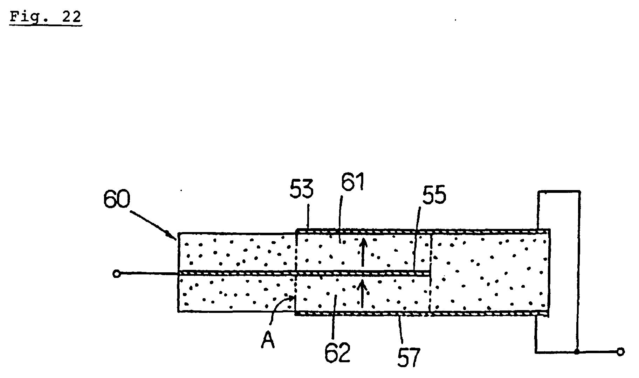

An energy-trapped piezoelectric resonator utilizing the second-order wave of a thickness extensional vibration mode is disclosed in Patent Unexamined Publication No. 117409/1989. This piezoelectric resonator is now described with reference to Figs. 21 and 22.

The above-described piezoelectric resonator is obtained by stacking ceramic green sheets 51, 52 of a piezoelectric material on top of each other and sintering them together, as shown in the exploded perspective view of Fig. 21. A circular excitation electrode 53 is formed in the center of the ceramic green sheet 51. The excitation electrode 53 is brought out to an end of the ceramic green sheet 51 by an extraction electrode 54. A circular excitation electrode 55 is formed in the center of the top surface of the ceramic green sheet 52. The excitation electrode 55 is brought out to an end of the ceramic green sheet 52 by an extraction electrode 56. As shown in the lower projected view, an excitation electrode 57 is formed on the bottom surface of the ceramic green sheet 52. The excitation electrode 57 is brought out to an end of the ceramic green sheet 52 by an extraction electrode 58.

The aforementioned ceramic green sheets 51 and 52 are stacked on top of each other and pressure is applied in the direction of thickness. Then, they are sintered, thus producing a sintered body. This sintered body is polarized. Thus, a piezoelectric resonator 60 is obtained, as shown in Fig. 22.

In the piezoelectric resonator 60, piezoelectric layers 61 and 62 are polarized uniformly in the direction of the arrows, i.e., in the direction of thickness.

When the device is driven, the excitation electrodes 53 and 57 are connected together, and an AC voltage is applied between the excitation electrodes 53, 57 and the excitation electrode 55. In this way, the piezoelectric resonator 60 can be made to resonate. In this case, the vibration energy is confined to a region where the excitation electrodes 53, 55, 57 superimpose each other, i.e., a resonating portion A.

The prior art piezoelectric resonator 60 making use of harmonics of a thickness extensional vibration mode is designed as an energy-trapped piezoelectric resonator as mentioned above. Therefore, it has needed vibration-attenuating portions around the resonating portion A for attenuating vibrations. That is, vibration-attenuating portions that are large compared with the area of the resonating portion are necessary. Consequently, it has been difficult to promote miniaturization of the piezoelectric resonator 60.

On the other hand, Patent Unexamined Publication No. 235422/1990 discloses an energy-trapped piezoelectric resonator that uses a piezoelectric ceramic strip and hardly needs extra piezoelectric substrate portions around the resonating portion.

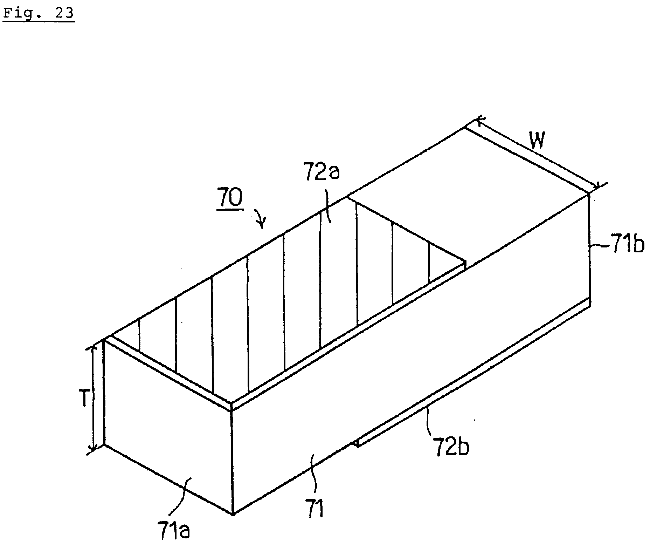

Here, as shown in Fig. 23, an excitation electrode 72a and an excitation electrode 72b are formed on the top and bottom surfaces, respectively, of an elongated piezoelectric substrate 71. The excitation electrodes 72a and 72b extend along the whole major dimensions of the piezoelectric substrate 71, and face away from each other in the longitudinal center of the piezoelectric substrate 71 to form a resonating portion. These excitation electrodes 72a and 72b extend to longitudinal ends 71a and 71b, respectively, of the piezoelectric substrate 71.

When the piezoelectric resonator 70 excites a thickness extensional vibration mode, unwanted vibrations occur due to the dimensional relation between the width W and the thickness T of the piezoelectric substrate 71. Accordingly, Patent Unexamined Publication No. 235422/1990 teaches that where the fundamental wave is used, $W/T = 5.33$ should be employed if the resonance frequency is 16 MHz, and that where the third-order wave is employed, setting W/T to approximately 2.87 (where the resonance frequency is approximately 16 MHz) can reduce unwanted spurious waves between resonant and antiresonant frequencies.

As described above, the energy-trapped piezoelectric resonator disclosed in Patent Unexamined Publication No. 117409/1989 and utilizing the second-order wave of a thickness extensional vibration mode needs large vibration-attenuating portions around the resonating portion. Hence, it is difficult to reduce the size of the resonator.

The energy-trapped piezoelectric resonator disclosed in Patent Unexamined Publication No. 235422/1990 necessitates no vibration-attenuating portions at sides of the resonating portion and so miniaturization can be attained. However, where harmonic waves of a thickness extensional vibration mode are utilized, various unwanted spurious waves appear, in addition to the spurious waves between the resonant and antiresonant frequencies. In consequence, effective resonant characteristics are not obtained.

Accordingly, it is an object of the present invention to provide a thickness extensional piezoelectric resonator that utilizes harmonic waves of a thickness extensional vibration mode and can be fabricated in smaller size and thus can effectively suppress unwanted spurious vibrations (hence have good resonant characteristics).

The invention provides a thickness extensional vibration mode piezoelectric resonator utilizing an $n$th-order harmonic of a thickness extensional vibration mode, said piezoelectric resonator comprising a rectangular piezoelectric plate having first and second faces opposite to each other, a first and a second excitation electrodes provided on said first and second faces respectively and opposed to each other via said piezoelectric plate, at least one internal electrode disposed in said piezoelectric plate and at least partially placed opposite to the first and second excitation electrodes, the opposing portion of said first and second excitation electrodes, said internal electrode and said piezoelectric plate defining a resonating portion, wherein W/d is less than 6.1 in which $d = t/n$, where W and t are a width and a thickness of said rectangular piezoelectric plate respectively and $n$ is an integral larger than 1.

By the above described structure, unwanted spurious vibrations due to cross-sectional edge modes and harmonics other than the used harmonic can be effectively suppressed. In consequence, a thickness extensional piezoelectric resonator having good resonant characteristics can be provided.

Preferably, the W/d of the above thickness extensional vibration mode piezoelectric satisfies any one of the following ranges:

$$W/d \leq 0.8,$$
$$1.05 \leq W/d \leq 2.0,$$
$$2.2 \leq W/d \leq 4.0,$$
$$4.3 \leq W/d \leq 4.8,$$
$$5.7 \leq W/d \leq 6.1$$

When the ratio W/d is set within any one of the five certain ranges described above, unwanted spurious vibrations due to cross-sectional edge modes and harmonics other than the used harmonic can be more effectively suppressed.

In the above thickness extensional vibration mode piezoelectric resonator, said thickness extensional vibration mode piezoelectric resonator may be an energy-trapped piezoelectric resonator having said resonating portion and vibration-attenuating portions along only one direction, and said first and second excitation electrodes may be provided so as to extend to or close to an end of said piezoelectric plate in a direction perpendicular to said direction.

When the resonator is constructed as described above, the resonator is built as an energy-trapped piezoelectric resonator. An amount of attenuation of vibration is exhibited in only one direction. A first and second excitation electrodes are formed so as to extend to or close to ends of the piezoelectric plate in a direction vertical to said direction. Therefore, it is not necessary to provide vibration-attenuating portions at sides of the resonating portion. Hence, miniaturization of the piezoelectric resonator can be promoted.

In the above thickness extensional vibration mode piezoelectric resonator, said piezoelectric plate may be an elongated strip type.

When an elongated piezoelectric strip is used as the piezoelectric plate, miniaturization of the thickness extensional piezoelectric resonator can be accelerated, and a thickness extensional piezoelectric resonator can be offered in still reduced size.

The above thickness extensional vibration mode piezoelectric resonator may further comprise a capacitor disposed on said first or second faces of said piezoelectric plate with a space therebetween, the space acting not to impede vibrations of the piezoelectric resonator.

According to the above structure, a piezoelectric resonator having a built-in capacitor can be offered, using a piezoelectric resonator having little unwanted spurious vibrations and good resonant characteristics.

BRIEF DESCRIPTION OF THE DRAWINGS

Fig. 1 is a perspective view showing a thickness extensional piezoelectric resonator according to a first embodiment of the invention;

Fig. 2 is a cross-sectional view of the thickness extensional piezoelectric resonator according to the first embodiment;

Fig. 3 is a cross-sectional view of a half of a piezoelectric resonator whose displacement distribution is shown in Figs. 4-8;

Fig. 4 is a diagram illustrating the distribution of displacements of a piezoelectric plate vibrating in a cross-sectional edge mode $SE_0$ analyzed by the finite element method;

Fig. 5 is a diagram illustrating the distribution of displacements of a piezoelectric plate vibrating in a cross-sectional edge mode $SE_1$ analyzed by the finite element method;

Fig. 6 is a diagram illustrating the distribution of displacements of a piezoelectric plate vibrating in a cross-sectional edge mode $SE_2$ analyzed by the finite element method;

Fig. 7 is a diagram illustrating the distribution of displacements of a piezoelectric plate vibrating in a cross-sectional edge mode $SE_3$ analyzed by the finite element method;

Fig. 8 is a diagram illustrating the distribution of displacements of a piezoelectric plate vibrating in a cross-sectional edge mode $SE_4$ analyzed by the finite element method;

Fig. 9 is a diagram illustrating the impedance-frequency characteristic where the ratio W/d is 4.2 and the analysis is made by the finite element method;

Fig. 10 is a diagram illustrating the impedance-frequency characteristic of the thickness extensional piezoelectric resonator where the ratio W/d is 2.8 and the analysis is made by the finite element method;

Fig. 11 is a diagram illustrating the impedance-frequency characteristics of a thickness extensional piezoelectric resonator according to a first embodiment of the invention;

Fig. 12 is a diagram illustrating the relation between the absolute value of the ratio W/d and relative bandwidth;

Fig. 13 is a perspective view illustrating a thickness extensional piezoelectric resonator according to a second embodiment of the invention;

Fig. 14 is a cross-sectional view showing a first modified example of a thickness extensional piezoelectric resonator according to the invention;

Fig. 15 is a cross-sectional view showing a second modified example of a thickness extensional piezoelectric resonator according to the invention;

Fig. 16 is a cross-sectional view showing a third modified example of a thickness extensional piezoelectric resonator according to the invention;

Fig. 17 is a cross-sectional view showing a fourth modified example of a thickness extensional piezoelectric resonator according to the invention;

Fig. 18 is a perspective view showing a piezoelectric resonator having a built-in capacitor, the resonator being built according to the third embodiment of the invention;

Fig. 19 is a diagram showing the circuit configuration of the piezoelectric resonator shown in Fig. 18;

Fig. 20 is a perspective view illustrating a further modified example of a thickness extensional piezoelectric resonator according to the invention;

Fig. 21 is an exploded perspective view illustrating one example of the prior art thickness extensional piezoelectric resonator;

Fig. 22 is a cross-sectional view of the thickness extensional piezoelectric resonator shown in Fig. 21;

Fig. 23 is a perspective view illustrating another example of the prior art thickness extensional piezoelectric resonator; and

Fig. 24 is a diagram illustrating the impedance-frequency characteristic of the prior art thickness extensional piezoelectric resonator.

## PREFERRED EMBODIMENTS OF THE PRESENT INVENTION

Other features and advantages of the present invention will become apparent from the following description of the invention which refers to the accompanying drawings.

(First Embodiment)

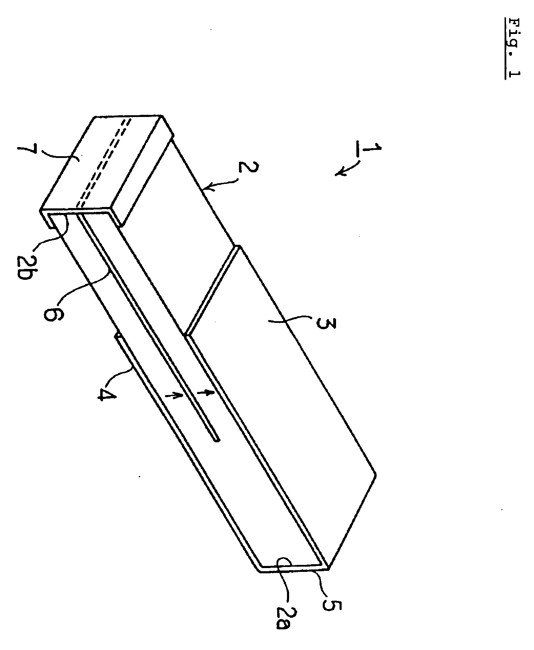

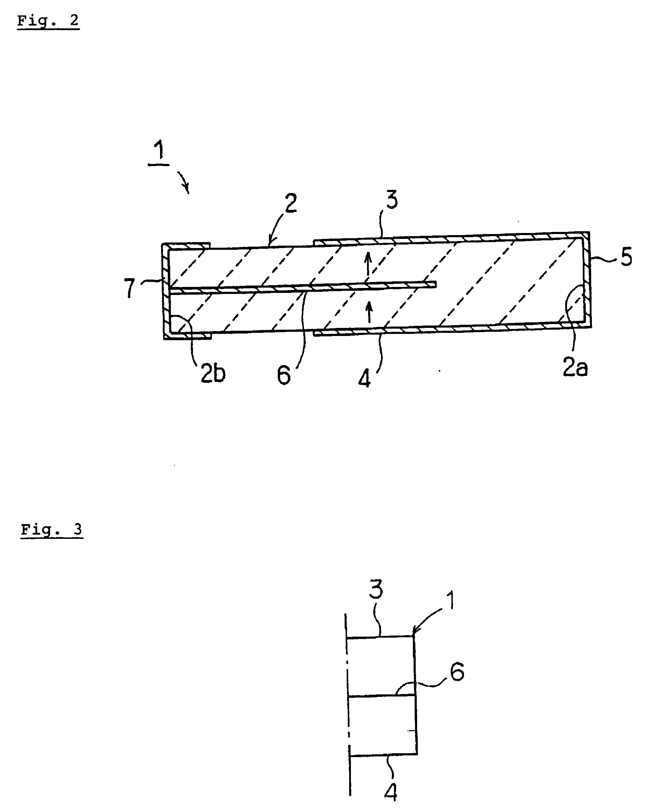

Fig. 1 is a perspective view showing a thickness extensional piezoelectric resonator according to a first embodiment of the invention. Fig. 2 is a cross-sectional view of the resonator.

A thickness extensional piezoelectric resonator 1 is made of an elongated piezoelectric strip 2 consisting of a piezoelectric ceramic such as a lead zirconate titanate-based ceramic. Assuming that the piezoelectric plate 2 has a width W and a thickness t, W/d is set less than 6.1 if $d = t/n$.

The piezoelectric strip 2 is polarized uniformly in the direction of thickness as indicated by the arrows in the figure. A first excitation electrode 3 is formed on the top surface of the piezoelectric strip 2. A second excitation electrode 4 is formed on the bottom surface. Excitation electrodes 3 and 4 extend from one end 2a of the piezoelectric strip 2 to the other end 2b at the top and bottom surfaces of the piezoelectric strip 2.

The excitation electrodes 3 and 4 are connected together by a connecting electrode 5 formed on the end surface 2a of the piezoelectric strip 2.

An internal electrode 6 is formed at a midway level within the piezoelectric strip 2. The internal electrode 6 is brought out to the end surface 2b of the piezoelectric strip 2, and is electrically connected with a terminal electrode 7 formed on the end surface 2b.

During operation, an AC voltage is applied between the first and second excitation electrodes 3,4 and the internal electrode 6, thus inducing the second-order wave of the thickness extensional vibration mode strongly. Thus, the resonator can be used as a piezoelectric resonator utilizing the second-order wave.

In the present embodiment, the first and second excitation electrodes 3 and 4 are stacked over the internal electrode 6 via the piezoelectric layer in the longitudinal center of the piezoelectric strip 2. Therefore, in the portion where the internal electrode 6 overlaps the first and second excitation electrodes 3, 4, an energy-trapped resonating portion is formed. When this resonating portion is resonating, the energy is attenuated by the piezoelectric portions extending from the resonating portion to the end surfaces 2a and 2b.

If the above-described resonating portion is taken as the center, vibration-attenuating portions are formed at longitudinally opposite sides only in the longitudinal direction (first direction) of the piezoelectric strip 2. The first and second excitation electrodes extend to the ends of the piezoelectric strip in a direction perpendicular to the longitudinal direction, i.e., to the longitudinal ends.

In this case, the first and second excitation electrodes 3, 4 and the internal electrode 6 are only required to extend along the whole width of the piezoelectric strip 2 only in the resonating portion 6. Outside the resonating portion, this width is not always required to be maintained. Take the excitation electrode 3 as an example. The excitation electrode 3 only needs to extend along the whole width of the piezoelectric strip 2 only in the resonating portion. The portion of the excitation electrode on the side of the end surface 2a may be thinner, because it simply electrically connects the excitation electrode with the connecting electrode 5.

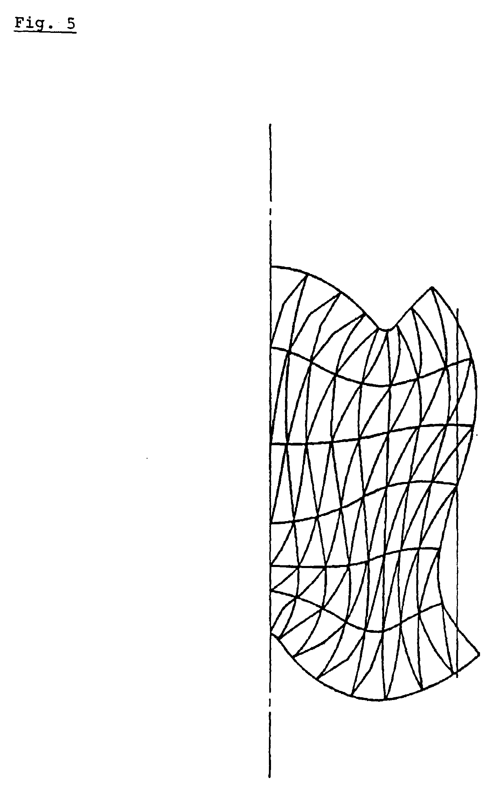

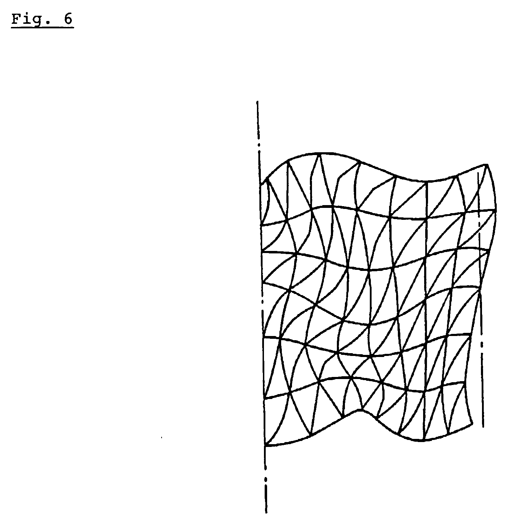

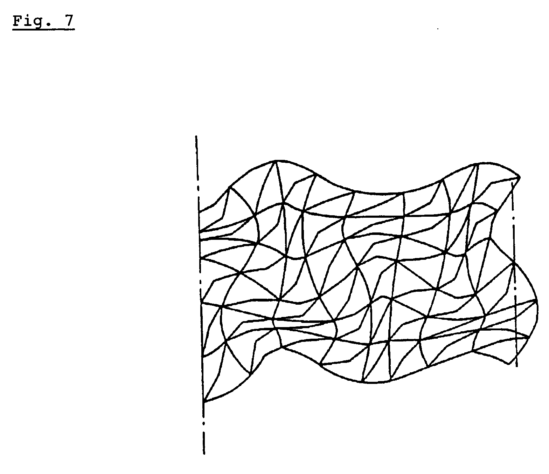

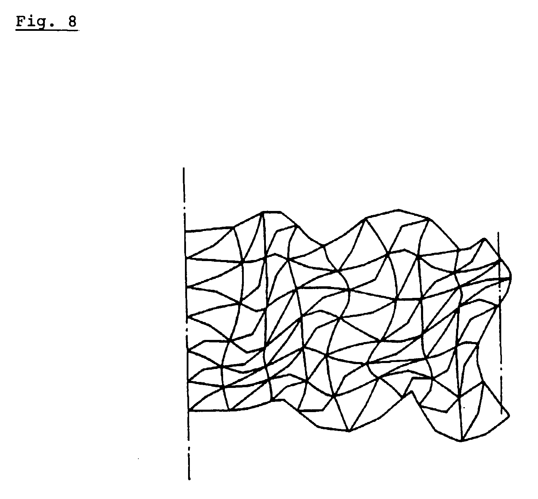

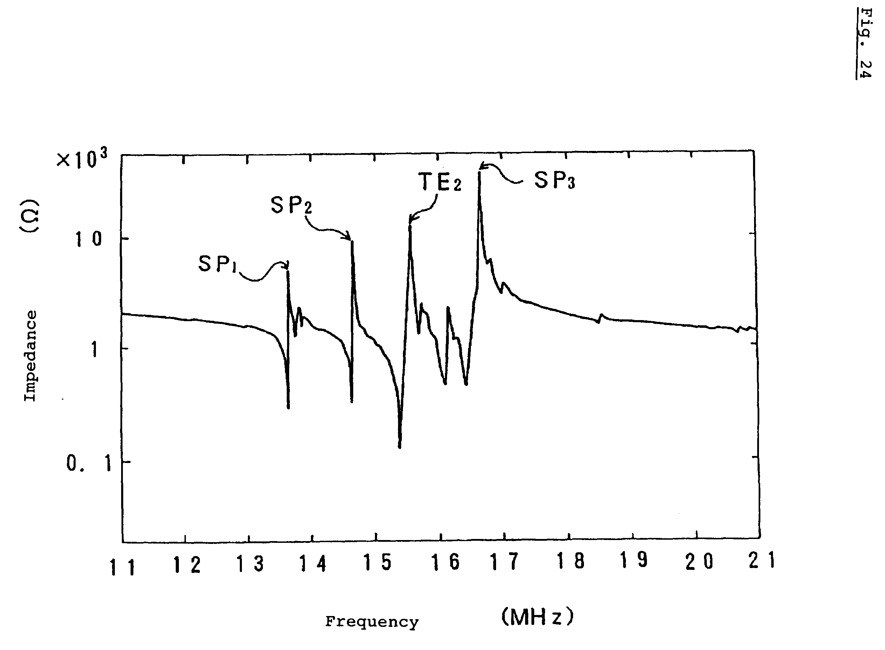

Unlike the prior art strip-type thickness extensional piezoelectric resonator, the thickness extensional piezoelectric resonator 1 according to the present embodiment can effectively suppress unwanted spurious vibrations due to lateral-mode vibrations, as will be described by referring to Figs. 24 and 3-11.

We have confirmed, using the present invention, that the prior art strip-type piezoelectric resonator 70 shown in Fig. 23 produces strong resonance due to cross-sectional edge mode of the piezoelectric substrate 71. Fig. 24 shows the impedance-frequency characteristic of this piezoelectric resonator 70.

In Fig. 24, a vibration mode indicated by the arrow $TE_2$ is the second-order wave of a thickness extensional vibration mode. Responses indicated by $SE_1$-$SE_3$ are spurious vibrations due to the cross-sectional edge mode. The impedance-frequency characteristic shown in Fig. 24 is derived from the piezoelectric resonator 70 having a resonance frequency of 16 MHz. As can be seen from Fig. 24, spurious vibrations indicated by $SP_1$, $SP_2$, and $SP_3$ appear near 13.5, 14.5, and 16.5 MHz, respectively. It is observed that every spurious vibration is considerably large.

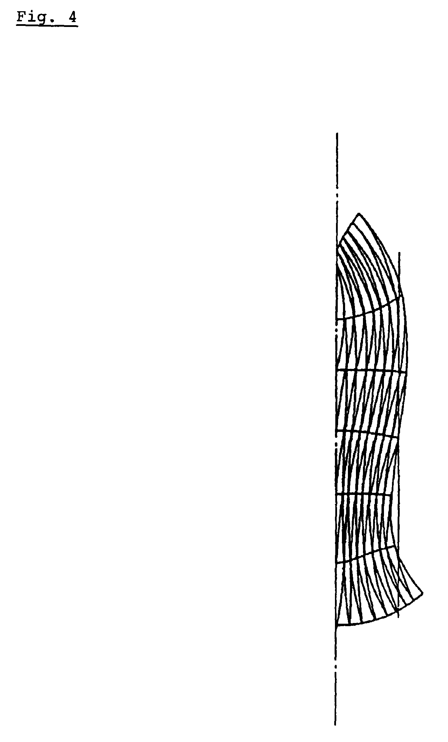

We have analyzed the displacements of the piezoelectric resonator at the spurious vibrations described above. Results shown in Figs. 4-8 have been obtained. Figs. 4-8 are horizontal cross sections of a thickness extensional piezoelectric resonator 1 in a strip form as shown in Fig. 3, schematically showing, on an enlarged scale, the displacements of a surface of a half of the strip-type piezoelectric resonator 1 when taken in a direction perpendicular to the longitudinal direction and in the direction of thickness.

Figs. 4-8 are modes of displacements of cross-sectional edge modes and referred to as $SE_0$-$SE_4$, respectively. It is considered that the $SP_1$, $SP_2$, and $SP_3$ are either based on cross-sectional edge mode spurious vibration $SE_2$ or accompany it.

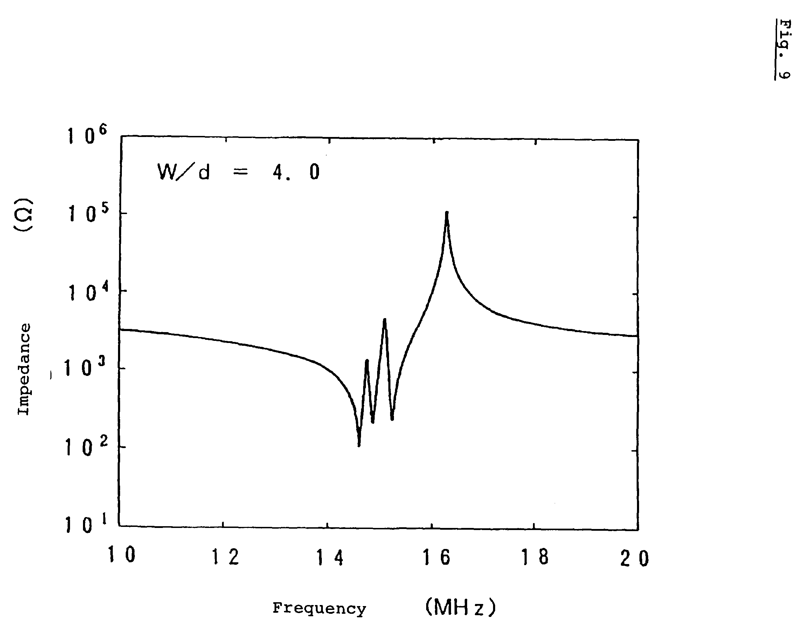

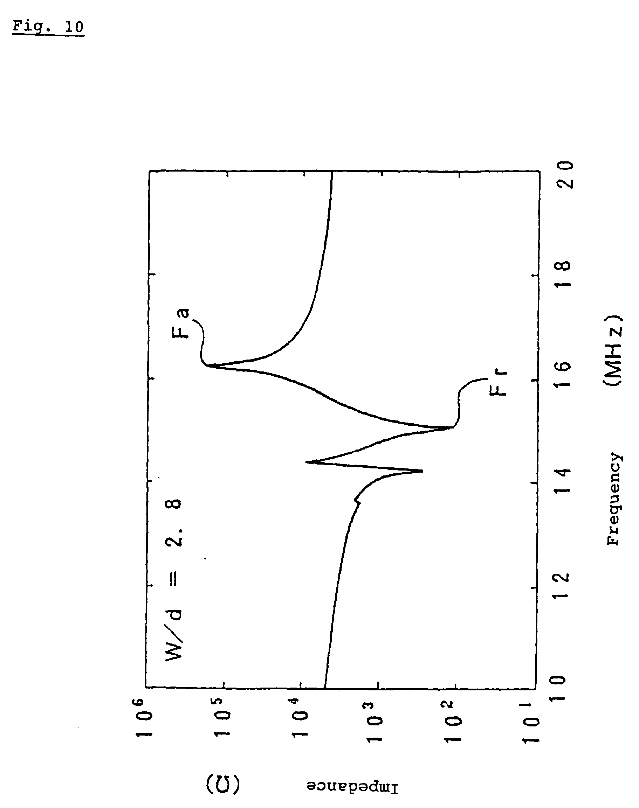

Accordingly, the inventors of the present application performed various experiments in an attempt to suppress the spurious vibrations due to the cross-sectional edge modes $SE_0$-$SE_4$ described above and have found that if the ratio W/d is set to a certain value under conditions where the piezoelectric plate 2 has a width W and a thickness t and $d = t/n$, the responses of the cross-sectional edge modes can be reduced, and that only the second-order wave $TE_2$ of the thickness extensional vibration mode can be excited strongly. That is, Figs. 9 and 10 show the impedance-frequency characteristics of the piezoelectric plate 1 under conditions where the ratio W/d = 4.2 and 2.8, the characteristics having been analyzed by the finite element method.

As can be seen from Fig.9, where W/d is 4.2, a cross-sectional edge mode $SE_2$ and associated modes appear strongly in the passband between a resonant point fr and an antiresonant point fa. As shown in Fig. 10, where W/d is 2.8, no large cross-sectional edge mode spurious vibrations appear near the passband between the resonant point fr and the antiresonant point fa.

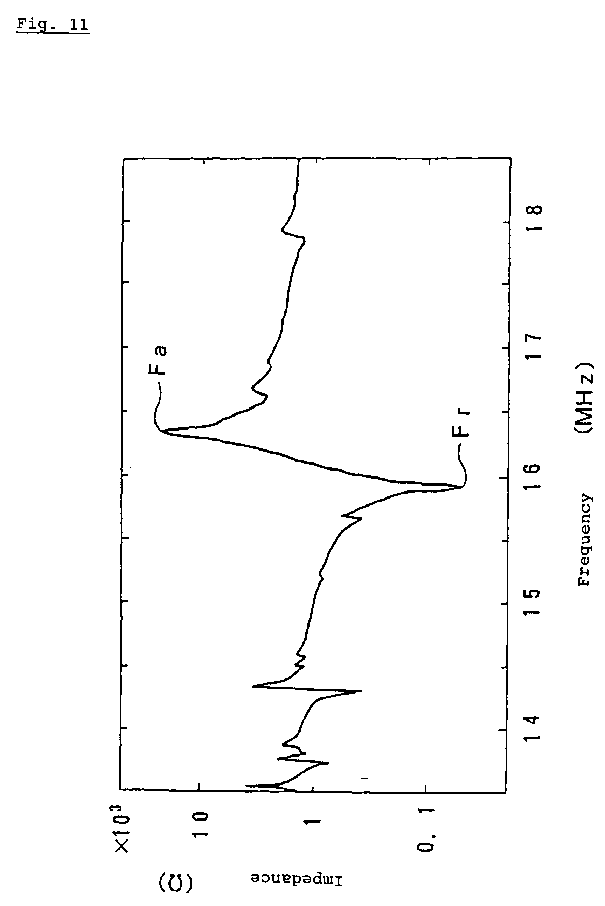

We actually manufactured the piezoelectric resonator 1 according to the analysis by the aforementioned finite element method such that W/d = 2.8. The impedance-frequency characteristic was measured, and results shown in Fig. 11 have been obtained.

As can be seen from Fig. 11, almost no spurious vibrations due to cross-sectional edge modes appear near the passband between the resonant point fr and the antiresonant point fa.

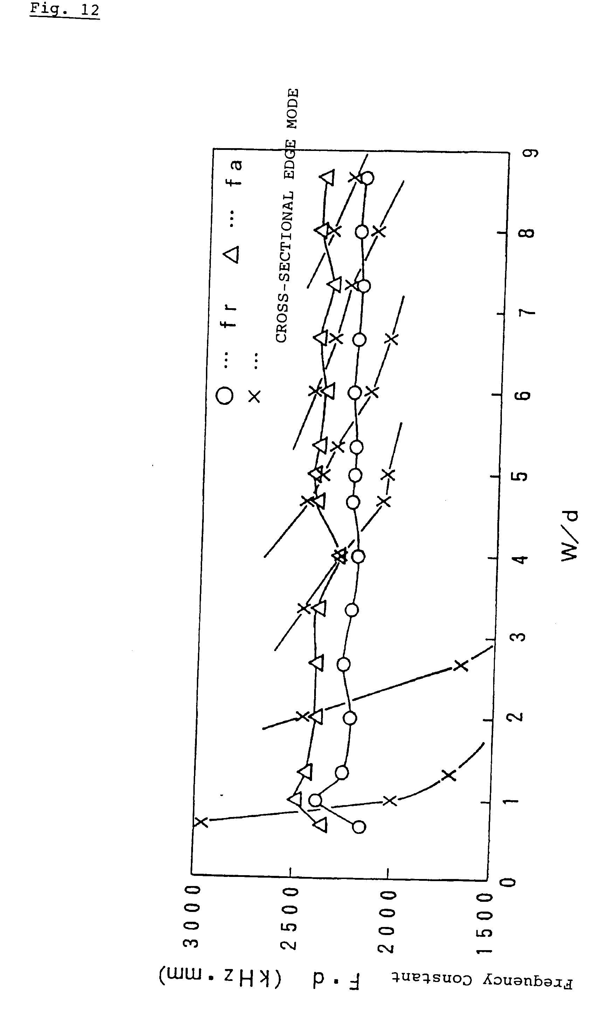

Where the ratio W/d described above was varied, good resonant characteristics were obtained as shown in Fig. 11. In view of this, the frequency constants of the modes obtained where the ratio was varied W/d were confirmed by the finite element method. Results shown in Fig. 12 are obtained.

The frequency constant referred to herein is the antiresonant frequency fa multiplied by d to make the frequency a constant.

As can be seen from Fig. 12, where the ratio W/d is changed, the relative bandwidth varies. Especially, where the W/d is in excess of 6, resonant points of vibrations due to cross-sectional edge modes (indicated by X in Fig. 12) appear in the passband. Where the ratio W/d is less than 6.1, a thickness extensional piezoelectric resonator insusceptible to vibrations due to cross-sectional edge modes can be derived by appropriately selecting the value of the ratio W/d. Especially, where the ratio W/d is set within the ranges of Eqs. (1)-(5), the resonance of cross-sectional edge mode indicated by X does not lie within the passband between the resonant point (O) and antiresonant point (△) and so good resonant characteristics can be obtained.

In the thickness extensional piezoelectric resonator 1 according to the present embodiment, the ratio W/d of the piezoelectric plate 2 is set less than 6.1 as mentioned above. Therefore, where a piezoelectric resonator utilizing the second-order wave $TE_2$ of a thickness extensional vibration mode is constructed, unwanted spurious vibrations due to cross-sectional edge modes can be effectively suppressed. In consequence, good resonant characteristics can be had.

(Second Embodiment)

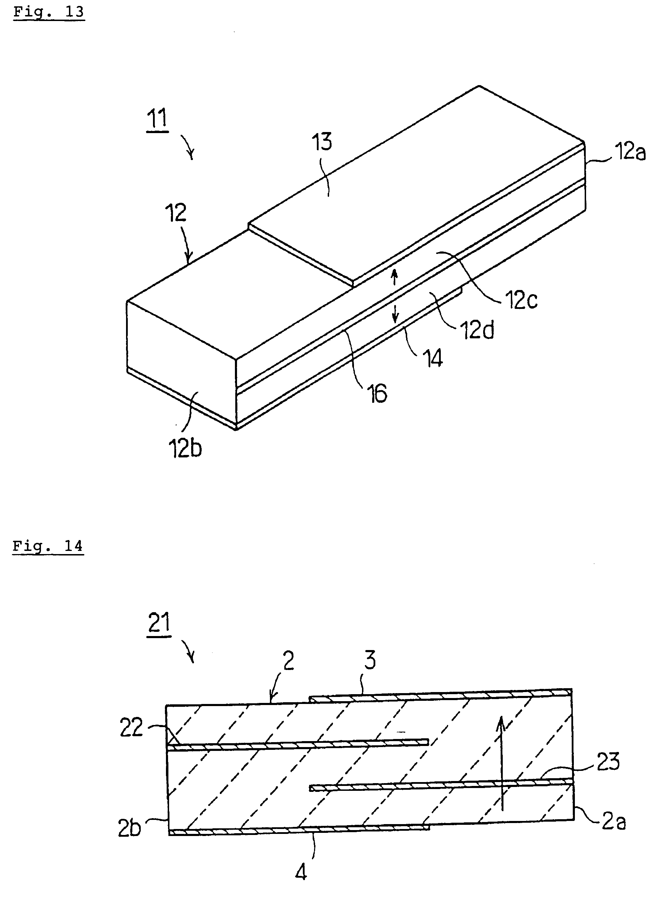

In the thickness extensional piezoelectric resonator 1 according to the first embodiment, the piezoelectric strip 2 is polarized uniformly in the direction of thickness. The piezoelectric resonator is connected in a parallel configuration such that the applied electric field is reversed with each of the successive layers. The invention may also be applied to a series-connection type piezoelectric resonator in which plural piezoelectric layers are polarized alternately oppositely in the direction of thickness. A thickness extensional piezoelectric resonator of such a series type is shown in Fig. 13.

A thickness extensional piezoelectric resonator, 11, shown in Fig. 13 is made of an elongated rectangular piezoelectric strip 12. A first excitation electrode 13 is formed on the top surface of the piezoelectric strip 12. A second excitation electrode 14 is formed on the bottom surface. The first and second excitation electrodes 13 and 14, respectively, are located on opposite side of the piezoelectric strip 12. The first and second excitation electrodes 13 and 14 are opposite to each other in the longitudinal center of the piezoelectric strip 12. The portion where the first and second excitation electrodes 13 and 14 are opposite to each other makes an energy-trapped resonating portion.

Also, in the present embodiment, the first and second excitation electrodes 13 and 14 are brought out to end surfaces 12a and 12b, respectively, of the piezoelectric strip 12. The portions other than the resonating portion are not required to extend along the whole length of the piezoelectric strip 12.

From a different viewpoint, the excitation electrodes 13 and 14 form an energy-trapped resonating portion having vibration-attenuating portions in the longitudinal direction of the piezoelectric strip 12. For this purpose, the first and second excitation electrodes 13 and 14 extend to the longitudinal ends of the piezoelectric strip 12 in a direction vertical to the longitudinal direction.

An internal electrode 16 is formed at a midway height within the piezoelectric strip 12, and acts to polarize the piezoelectric strip 12. That is, during polarization, piezoelectric layers 12c and 12d are polarized in opposite directions in the direction of thickness as indicated by the arrows by applying a higher voltage and a lower voltage to the internal electrode 16 and the excitation electrodes 13, 14, respectively.

During operation, an AC voltage is applied between the first and second excitation electrodes 13 and 14, respectively. That is, the internal electrode 16 is not used for the operation. The second-order wave $TE_2$ of a thickness extensional vibration mode can be excited.

In the same way as the thickness extensional vibration mode piezoelectric resonator 1 according to the first embodiment, the thickness extensional vibration mode piezoelectric resonator 11 according to the second embodiment can effectively suppress unwanted spurious vibrations due to cross-sectional edge modes, since the ratio W/d is set within any one of the five ranges described above. As a result, good resonant characteristics can be obtained.

(Modified Example)

The first and second embodiments provide piezoelectric resonators 1 and 11 both utilizing the second-order wave of a thickness extensional vibration mode. Piezoelectric resonators in accordance with the present invention may make use of harmonics other than the second-order wave of a thickness extensional vibration mode. Figs. 14-17 are cross-sectional views illustrating piezoelectric resonators utilizing these harmonics, and correspond to Fig. 2 used to describe the first embodiment.

Fig. 14 is a parallel-connection type thickness extensional piezoelectric resonator, 21, utilizing the third-order wave of a thickness extensional vibration mode. In particular, two internal electrodes 22 and 23 are disposed in a piezoelectric body 2. The piezoelectric body 2 is polarized uniformly in the direction of thickness as indicated by the arrow. Thus, the piezoelectric resonator 21 exploiting the third-order wave of a thickness extensional vibration mode can be built.

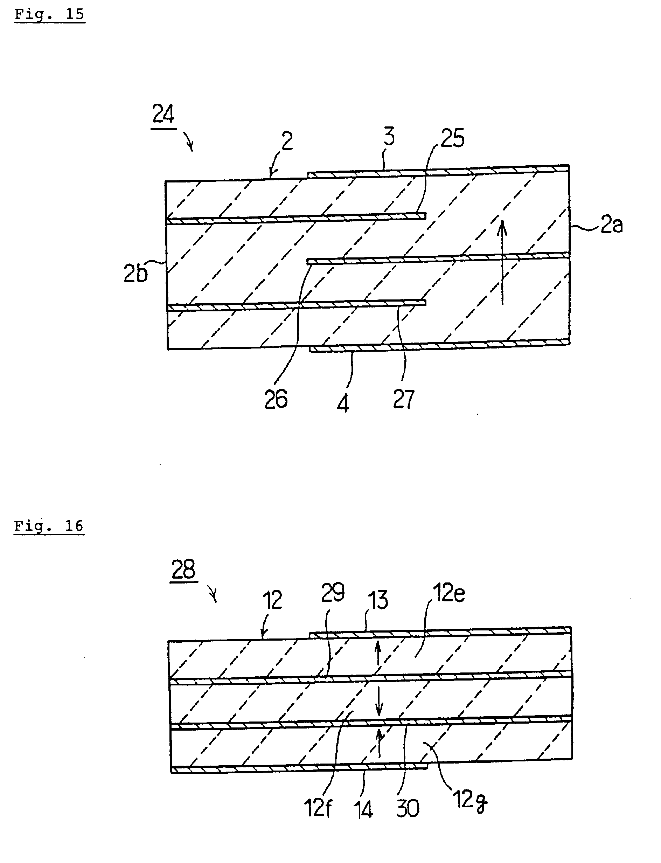

A thickness extensional piezoelectric resonator, 24, shown in Fig. 15 is a cross-sectional view showing a parallel-connection type piezoelectric resonator 24 utilizing the fourth-order wave of a thickness extensional vibration mode. In the thickness extensional piezoelectric resonator 24, the piezoelectric strip 2 is polarized uniformly in the direction of thickness. Three internal electrodes 25-27 are regularly spaced from each other in the direction of thickness inside the resonator. Consequently, the fourth-order wave of a thickness extensional vibration mode is effectively excited.

Fig. 16 is a cross-sectional view showing a series-connection type thickness extensional piezoelectric resonator, 28, utilizing the third-order wave of a thickness extensional vibration mode. In this thickness extensional piezoelectric resonator 28, two internal electrodes 29 and 30 are disposed in a piezoelectric body 12. The inside of the piezoelectric body 12 is divided into three layers of piezoelectric layers 12e-12g. Polarization is performed, using these internal electrodes 29 and 30, so that piezoelectric layers adjacent to each other in the direction of thickness are polarized in opposite directions. Thus, the third-order wave of a thickness extensional vibration mode can be excited by applying an AC voltage to the first and second excitation electrodes 13 and 14.

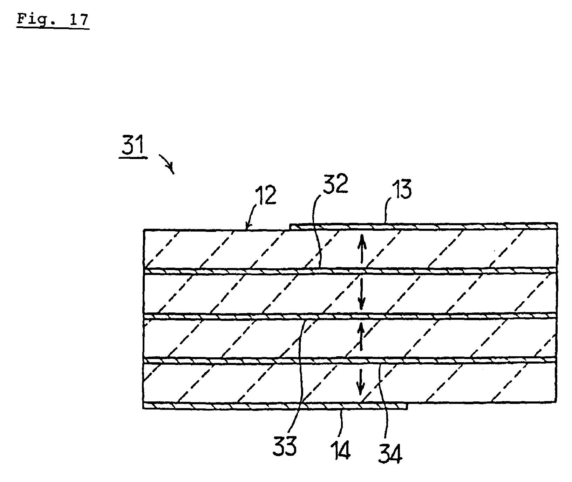

Similarly, Fig. 17 is a cross-sectional view showing a series-connection type piezoelectric resonator, 31, utilizing the fourth-order wave of a thickness extensional vibration mode. Here, three internal electrodes 32-34 are disposed in a piezoelectric body 12. Polarization is carried out, using these internal electrodes 32-34, such that piezoelectric layers adjacent to each other in the direction of thickness are polarized in opposite directions.

Therefore, it can be operated as a piezoelectric resonator utilizing the fourth-order wave of a thickness extensional vibration mode by applying an AC voltage from the first and second excitation electrodes 13, 14.

Also, in the thickness extensional piezoelectric resonators shown in Figs. 14-17, the ratio W/d is set within any one of the five ranges described above. Therefore, harmonics of a thickness extensional vibration can be exploited, in the same way as the first and second embodiments. Furthermore, unwanted spurious vibrations due to responses of cross-sectional edge modes or other harmonics can be effectively suppressed.

(Third Embodiment)

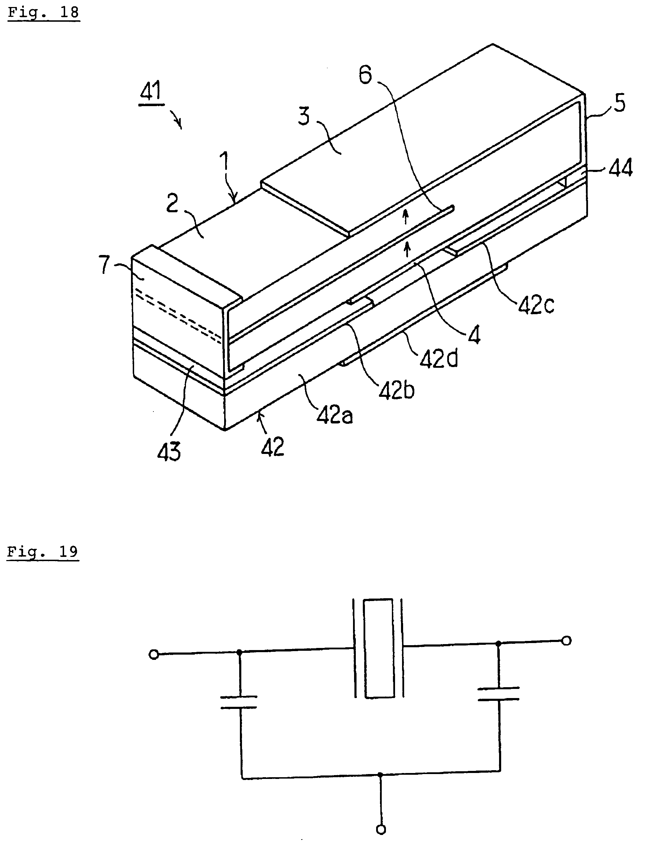

Fig. 18 is a perspective view for illustrating a thickness extensional piezoelectric resonator according to a third embodiment of the invention. Fig. 19 is a diagram showing its equivalent circuit. Fig. 18 shows a piezoelectric resonator 41 that is a combination of the thickness extensional piezoelectric resonator 1 according to the first embodiment and a capacitor 42. This capacitor 42 is bonded to the bottom surface of the thickness extensional piezoelectric resonator 1 via conductive adhesive 43, 44.

In the capacitor 42, capacitive electrodes 42b and 42c are formed via a given gap on the top surface of a dielectric substrate 42a. A common electrode 42d is formed on the bottom surface of the dielectric substrate 42a. The common electrode 42d and the capacitive electrodes 42b, 42c are located on opposite sides of the dielectric substrate 42a.

The conductive adhesive 43 bonds the capacitive electrode 42b to a terminal electrode 7. The conductive adhesive 44 bonds the capacitive electrode 42c to a terminal electrode 5.

Therefore, as shown in Fig. 19, the piezoelectric resonator 41 can be used as a piezoelectric resonator incorporating two capacitive units.

Thus, the thickness extensional piezoelectric resonator 1 is a piezoelectric resonator utilizing the second-order waves of thickness extensional vibrations. Spurious vibrations attributed to cross-sectional edge modes can be effectively suppressed. Therefore, piezoelectric resonators having good frequency characteristics can be offered.

(Other Modified Example)

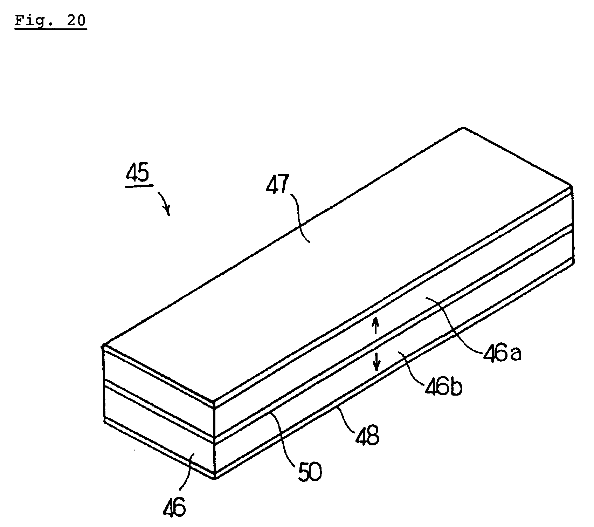

Fig. 20 is a perspective view showing a further modified example of the thickness extensional piezoelectric resonator in accordance with the present invention.

A thickness extensional piezoelectric resonator in accordance with the present invention is characterized in that the resonator makes use of harmonics of a thickness extensional vibration mode and that the ratio W/d is set within the five certain ranges described above. Thus, unwanted spurious vibrations due to cross-sectional edge modes and other harmonics are suppressed. That is, the invention is not limited to an energy-trapped piezoelectric resonator. As shown in Fig. 20, the invention can also be applied to a thickness extensional piezoelectric resonator other than the energy-trapped type.

Referring to Fig. 20, a thickness extensional piezoelectric resonator 45 comprises an elongated, rectangular piezoelectric strip 46. The ratio W/d of this piezoelectric strip 46 is set within any one of the five certain ranges described in connection with the first embodiment. A first excitation electrode 47 and a second excitation electrode 48 are formed over the whole top surface and over the whole bottom surface, respectively, of the piezoelectric strip 46. An internal electrode 50 is disposed inside the piezoelectric strip. In this piezoelectric strip 46, adjacent piezoelectric layers 46a and 46b are polarized oppositely in the direction of thickness.

Also, in the piezoelectric resonator 45, the W/d is set within the certain ranges described above. Unwanted spurious vibrations due to cross-sectional edge modes and other harmonics can be effectively suppressed, in the same way as in the thickness extensional piezoelectric resonator 11 according to the second embodiment. Good resonant characteristics can be obtained.

While the invention has been particularly shown and described with reference to preferred embodiments thereof, it will be understood by those skilled man in the art that the forgoing and other changes in form and details may be made therein without departing from the spirit of the invention.

## Claims

1. A thickness extensional vibration mode piezoelectric resonator utilizing an $n$th-order harmonic of a thickness extensional vibration mode, said piezoelectric resonator comprising:

   a rectangular piezoelectric plate having first and second faces opposite to each other;
   a first and a second excitation electrodes provided on said first and second faces respectively and opposed to each other via said piezoelectric plate;
   at least one internal electrode disposed in said piezoelectric plate and at least partially placed opposite to the first and second excitation electrodes,
   the opposing portion of said first and second excitation electrodes, said internal electrode and said piezoelectric plate defining a resonating portion; wherein W/d is less than 6.1 in which $d = t/n$, where W and t are a width and a thickness of said rectangular piezoelectric plate respectively and $n$ is an integral larger than 1.

2. The thickness extensional vibration mode piezoelectric resonator according to claim 1, wherein said W/d satisfies any one of the following ranges:

   W/d ≤ 0.8,
   1.0 ≤ W/d ≤ 2.0,
   2.2 ≤ W/d ≤ 4.0,
   4.3 ≤ W/d ≤ 4.8,
   5.7 ≤ W/d ≤ 6.1.

3. The thickness extensional vibration mode piezoelectric resonator according to claim 2, wherein;

said thickness extensional vibration mode piezoelectric resonator is an energy-trapped piezoelectric resonator having said resonating portion and vibration-attenuating portions along only one direction, and;

said first and second excitation electrodes are provided so as to extend to or close to both ends of said piezoelectric plate in a direction perpendicular to said direction.

4. The thickness extensional vibration mode piezoelectric resonator according to claim 1, wherein;

said thickness extensional vibration mode piezoelectric resonator is an energy-trapped piezoelectric resonator having said resonating portion and vibration-attenuating portions along only one direction, and;
said first and second excitation electrodes are provided so as to extend to or close to an end of said piezoelectric plate in a direction perpendicular to said direction.

5. The thickness extensional vibration mode piezoelectric resonator of any one of claims 1 to 4, wherein said piezoelectric plate is an elongated strip type.

6. The thickness extensional vibration mode piezoelectric resonator of any one of claims 1 to 5, further comprising a capacitor disposed on said first or second faces of said piezoelectric plate with a space therebetween, the space acting not to impede vibrations of the piezoelectric resonator.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

Fig. 22

Fig. 23

Fig. 24